(19) Europäisches Patentamt
European Patent Office
Office européen des brevets

(11) Veröffentlichungsnummer: **0 007 059**
**B1**

(12) **EUROPÄISCHE PATENTSCHRIFT**

(45) Veröffentlichungstag der Patentschrift: **15.04.81**

(51) Int. Cl.³: **G 03 C 1/68, C 08 F 2/50**

(21) Anmeldenummer: **79102253.6**

(22) Anmeldetag: **04.07.79**

(54) **Photohärtbares Gemisch.**

(30) Priorität: **13.07.78 CH 7621/78**

(43) Veröffentlichungstag der Anmeldung:
**23.01.80 Patentblatt 80/2**

(45) Bekanntmachung des Hinweises auf die Patenterteilung:
**15.04.81 Patentblatt 81/15**

(84) Benannte Vertragsstaaten:
**CH DE FR GB**

(56) Entgegenhaltungen:
**DE - A - 2 719 131**
**FR - A - 2 324 648**
**US - A - 4 024 296**

(73) Patentinhaber: **CIBA-GEIGY AG**
**Patentabteilung Postfach**
**CH-4002 Basel (CH)**

(72) Erfinder: **Berner, Godwin, Dr.**
**Oetlingerstrasse 2**
**CH-4057 Basel (CH)**

**EP 0 007 059 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Photohärtbares Gemisch

Die Erfindung betrifft photohärtbare Gemische aus einer oder mehreren photohärtbaren, äthylenisch ungesättigten Verbindungen, einem Photoinitiator und einem Lichtschutzmittel, das gegebenenfalls noch sonstige übliche Additive enthalten kann.

Es ist bekannt, dass man die Photopolymerisation äthylenisch ungesättigter Verbindungen durch den Zusatz von Photoinitiatoren erheblich beschleunigen kann. Dies ist für die technische Anwendung von Photopolymerisationen, beispielsweise für Lacke, Beschichtungen, Formmassen oder Druckfarben von entscheidender Bedeutung. Es sind verschiedene Klassen von organischen Verbindungen als Photohärter bekannt geworden, beispielsweise Derivate von Benzophenon, von Benzoin, von Acetophenon oder von Benzil. Im US-Patent No. 4,038,164 wurden auch bereits Ester der Phenylglyoxylsäure als Photoinitiatoren vorgeschlagen.

Für bestimmte Anwendungen der Photopolymerisation besteht ein Bedürfnis, die ausgehärteten Massen gegen Vergilbung oder Abbau durch Lichteinwirkung zu schützen. Dies ist vor allem bei der Anwendung für unpigmentierte Ueberzüge und Formmassen der Fall wie z.B. bei Klarlacken, Beschichtungen von Kunststoffen oder Beschichtungen von bedruckten Papier- und Pappartikeln.

Die naheliegende Lösung des Problems wäre der Zusatz von Lichtschutzmitteln, wie sie zum Stabilisieren von Kunststoffen und Lacken üblich sind. Solche Lösungen wurden bereits vorgeschlagen beispielsweise in der DE - OS 1 694 253 die Kombination von Benzoinäthern als Photoinitiatoren mit UV-Absorbern als Lichtschutzmittel. Diese UV-Absorber haben den Nachteil, auf Grund ihrer UV-Absorption die Photopolymerisation zu verzögern. Die durch Zusatz eines Photoinitiators erzielte Beschleunigung der Photopolymerisation wird also durch den verwendeten UV-Absorber teilweise wieder aufgehoben, vor allem wenn der UV-Absorber in einer Menge von über 0,3% verwendet wird.

Ein Fortschritt lässt sich erzielen, wenn man anstelle der UV-Absorber Lichtschutzmittel aus der Klasse der Polyalkylpiperidinderivate verwendet. Diese verzögern die Härtungsgeschwindigkeit nicht, selbst wenn sie in Mengen von 1—2% verwendet werden. Die Piperidinderivate haben jedoch den Nachteil, dass sie mit den meisten Photoinitiatoren nach der UV-Härtung eine Gelbfärbung der polymerisierten Masse bewirken.

Es wurde nun überraschend gefunden, dass eine solche Gelbfärbung durch Piperidin-Lichtschutzmittel in wesentlich geringerem Ausmass eintritt, wenn man als Photoinitiatoren ganz bestimmte Verbindungen verwendet. Gegenstand der Erfindung sind daher photohärtbare Gemische, bestehend aus

a) einer oder mehreren äthylenisch ungesättigten, photohärtbaren Verbindungen,

b) mindestens einem Photoinitiator der Formel I,

$$\mathrm{Ar{-}\overset{\overset{\displaystyle O}{\|}}{C}{-}COOR} \qquad (I)$$

worin Ar einen unsubstituierten oder durch $C_1$—$C_4$-Alkyl, $C_1$—$C_4$-Alkoxy, Phenoxy, $C_1$—$C_4$-Alkylthio, Phenylthio oder Halogen mono-, di- oder trisubstituierten $C_6$—$C_{14}$-Arylrest darstellt und R $C_1$—$C_{12}$-Alkyl, $C_5$—$C_6$-Cycloalkyl, $C_6$—$C_{10}$-Aryl oder Alkaryl, $C_7$—$C_{11}$-Aralkyl oder $C_3$—$C_6$-Alkoxyalkyl darstellt,

c) mindestens einem Lichtschutzmittel aus der Klasse der Polyalkylpiperidinderivate und

d) gegebenenfalls einem oder mehreren sonstigen in der Kunststofftechnologie üblichen Additiven.

Erfindungsgemäss verwendbare äthylenisch ungesättigte Verbindungen sind die dem Fachmann bekannten photohärtbaren Monomeren, Oligomeren oder Polymeren. Solche Monomere mit einer oder mehreren photopolymerisierbaren Doppelbindungen sind beispielsweise die Ester von Acryloder Methacrylsäure, z.B. Methyl-, Aethyl-, n- oder tert. Butyl-, Isooctyl-, 2-Aethylhexyl-, Phenyl-, Benzyl-, 2-Hydroxyäthyl- oder 2-Hydroxypropylacrylat, Methyl- oder Aethylmethacrylat, Aethylen-diacrylat, Neopentyl-diacrylat, Trimethylolpropantrisacrylat, Pentaerythrit-tetraacrylat oder Pentaerythrit-trisacrylat; Acrylnitril, Methacrylnitril, Acrylamid, Methacrylamid, N-substituierte (Meth)acrylamide; Vinylester wie z.B. Vinyl-acetat, -propionat, -acrylat oder -succinat; sonstige Vinylverbindungen wie Vinyläther, Styrol, Alkylstyrol, Halogenstyrol, Divinylbenzol, Vinylnaphthalin, N-Vinylpyrrolidon, Vinylchlorid oder Vinylidenchlorid; Allylverbindungen wie Diallylphthalat, Diallylmaleat, Triallylisocyanurat, Triallylphosphat oder Aethylenglycol-diallyläther und die Mischungen von solchen ungesättigten Monomeren.

Photopolymerisierbare ungesättigte Oligomere oder Polymere sind beispielsweise thermoplastische Harze, die ungesättigte Gruppen wie Fumarsäureester, Allylgruppen oder Acrylat- oder Methacrylatgruppen enthalten, ungesättigte Polyester, ungesättigte Acrylharze und Isocyanat- oder Epoxid-modifizierte Acrylatoligomere sowie Polyester- und Polyätheracrylatoligomere. Photopolymerisierbare Polymere werden vorzugsweise im Gemisch mit photopolymerisierbaren Monomeren verwendet. Bevorzugt als Komponente (a) werden Acryl- und Methacrylsäurederivate und deren Mischungen, besonders bevorzugt werden Polyurethanacrylate und deren Gemische mit anderen Acryl-

oder Methacrylsäurederivaten. Solche Polyurethanacrylate werden aus Polyolen oder Polyätherdiolen durch Umsetzung mit überschüssigem Diisocyanat und anschliessende Umsetzung mit Hydroxyalkylacrylaten hergestellt.

Die erfindungsgemäss als Komponente (b) verwendeten Photoinitiatoren der Formel I sind bekannte Verbindungen und wurden im US-Patent 4,038,164 als Photoinitiatoren beschrieben. Es handelt sich um Ester von Arylglyoxylsäuren.

Beispiele für den Rest Ar in Formel I sind Phenyl, Naphthyl, Phenanthryl, Diphenylyl, Tolyl, Xylyl, tert.-Butylphenyl, Isopropylphenyl, Methoxy-, Aethoxy- oder Isopropoxyphenyl, Butoxynaphthyl, Phenoxyphenyl, Methylthiophenyl, tert.-Butylthiophenyl, Phenylthionaphthyl, Chlorphenyl, Bromnaphthyl, Dibromphenyl, Chlortolyl, Methoxyxylyl oder Dichlortolyl. Bevorzugt ist Ar Phenyl oder Alkylphenyl, besonders bevorzugt Phenyl.

R in der Bedeutung Alkyl kann beispielsweise Methyl, Aethyl, Isopropyl, Butyl, tert.-Butyl, Isopentyl, Hexyl, Octyl, 2-Aethylhexyl, Decyl oder Dodecyl sein. R in der Bedeutung von Aryl oder Alkaryl kann beispielsweise Phenyl, Naphthyl, Tolyl oder Butylphenyl sein. R in der Bedeutung von Aralkyl kann z.B. Benzyl, Phenyläthyl, Phenylpropyl oder Naphthylmethyl sein. R als Alkoxyalkyl kann z.B. Methoxyäthyl, Aethoxyäthyl, Isopropoxyäthyl oder Methoxypropyl sein. Bevorzugt ist R $C_1$—$C_4$-Alkyl, insbesondere Methyl oder Aethyl.

Beispiele für verwendbare Photoinitiatoren der Formel I sind:

Phenylglyoxylsäure-methylester
Phenylglyoxylsäure-äthylester
Phenylglyoxylsäure-benzylester
Phenylglyoxylsäure-2-äthylhexylester
Phenylglyoxylsäure-phenylester
Phenylglyoxylsäure-2-äthoxyäthylester
p-Chlorphenylglyoxylsäure-äthylester
p-Phenoxyphenylglyoxylsäure-äthylester
m-Methoxyphenylglyoxylsäure-methylester
p-Isopropylphenylglyoxylsäure-methylester
p-Methylthiophenylglyoxylsäure-methylester
o-Tolylglyoxylsäure-butylester
2-Naphthylglyoxylsäure-hexylester
1-Brom-2-naphthylglyoxylsäure-äthylester
2,4-Dibromphenylglyoxylsäure-äthylester

In bestimmten Fällen kann es von Vorteil sein, ein Gemisch von 2 oder mehr Verbindungen der Formel I als Photoinitiator zu verwenden, beispielsweise zur Verbesserung der Löslichkeit.

Die Menge der Photoinitiatoren in der photohärtbaren Zusammensetzung beträgt 0,1 bis 10 Gew.-%. Geschieht die Photohärtung unter Sauerstoffausschluss, beispielsweise unter Stickstoff, so genügen etwa 0,1—1 Gew.-%; arbeitet man unter Luft, so benötigt man etwa 2—5 Gew.-%.

Die erfindungsgemäss als Lichtschutzmittel der Komponente (c) verwendeten Polyalkylpiperidinderivate sind monomere, oligomere oder polymere Verbindungen, die einen Rest der Formel

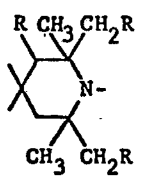

enthalten, worin R Wasserstoff oder Methyl ist, vorzugsweise jedoch Wasserstoff ist. Solche Verbindungen sind bekannte Lichtschutzmittel, insbesondere die 4-Acyloxypiperidinderivate wie sie beispielsweise in den DE - OS 1 929 928 und 2 258 752 beschrieben sind und die 4-Aminopiperidinderivate, wie sie z.B. in den DE - OS 2 040 975 und 2 349 962 beschrieben sind. Diese Piperidin-Lichtschutzmittel können auch ungesättigte Gruppen enthalten, die photopolymerisierbar sind wie z.B. 4-Acryloxypiperidin, 4-Acrylamidopiperidine oder 1-(Meth)acryloylpiperidine. In diesem Falle kann bei der Photohärtung eine Copolymerisation des Lichtschutzmittels mit der Komponente (a) eintreten. Ein solcherart einpolymerisiertes Lichtschutzmittel hat den Vorteil, dass es nicht durch Extraktion oder Migration entfernbar ist, sodass seine Wirkung sehr lange anhält. Einen ähnlichen Effekt erreicht man auch durch Verwendung von oligomeren oder polymeren Piperidin-Lichtschutzmitteln, wie sie z.B. in der DE - OS 27 19 131 oder in der EP - A - 0000496 beschrieben sind. Weiterhin können die Piperidin-Lichtschutzmittel auch sterisch gehinderte Phenolgruppen enthalten, wodurch sie gleichzeitig als Antioxydans wirken. Solche Verbindungen sind beispielsweise in der DE - OS 24 56 864 oder 26 47 452 beschrieben.

Die Piperidin-Lichtschutzmittel können auch in Form ihrer Salze mit anorganischen oder organischen Säuren verwendet werden sowie in Form ihrer Komplexe mit Nickelverbindungen, wie sie in der DE-OS 26 25 967 und in der EP - A - 0001840 beschrieben sind.

In bestimmten Fällen kann der Zusatz der Piperidin-Lichtschutzmittel auch eine Beschleunigung der Photohärtung bewirken, was ein zusätzlicher Vorteil ist.

Beispiele für verwendbare Lichtschutzmittel aus der Klasse der Polyalkylpiperidinderivate sind:

4-Benzoyloxy-2,2,6,6-tetramethylpiperidin
4-Stearoyloxy-2,2,6,6-tetramethylpiperidin
4-Acryloxy-2,2,6,6-tetramethylpiperidin
4-(p-Chlorbenzoyloxy)-1,2,2,6,6-pentamethylpiperidin
4-Lauroyloxy-1,2,2,6,6-pentamethylpiperidin
4-Methacryloxy-1,2,2,6,6-pentamethylpiperidin
1-Allyl-2,2,6,6-tetramethyl-4-piperidinyl-salicylat
1-(2-Benzoyloxyäthyl)-2,2,6,6-tetramethyl-4-piperidinylbenzoat
Bis-(1,2,2,6,6-pentamethyl-4-piperidinyl)-isophthalat
Bis-(1,2,2,6,6-pentamethyl-4-piperidinyl)-adipat
Bis-(2,2,6,6-tetramethyl-4-piperidinyl)-sebacat
Bis-(1-acetyl-2,2,6,6-tetramethyl-4-piperidinyl)-sebacat
Bis-(1-hydroxyäthyl-2,2,6,6-tetramethyl-4-piperidinyl)-succinat
Bis-(1-benzyl-2,2,6,6-tetramethyl-4-piperidinyl)-sebacat
Bis-(1-allyl-2,2,6,6-tetramethyl-4-piperidinyl)-adipat
Bis-(1,2,2,6,6-pentamethyl-4-piperidinyl)-sebacat
Tris-(2,2,6,6-tetramethyl-4-piperidinyl)-nitrilotriacetat
Tris-(1-butyl-2,2,6,6-tetramethyl-4-piperidinyl)-trimellithat
Tris-(1-butyl-2,2,6,6-tetramethyl-4-piperidinyl)-phosphat
Diphenyl-bis-(2,2,6,6-tetramethylpiperidin-4-oxy)-silan
Dibutylmalonsäure-di(1,2,2,6,6-pentamethyl-4-piperidinyl)-ester
Butyl-(3,5-di-tert.-butyl-4-hydroxybenzyl)-malonsäure-di-(2,2,6,6-tetramethyl-4-piperidinyl)-ester
O,O'-Di(2,2,6,6-tetramethyl-4-piperidinyl)-tolylen-1,4-dicarbamat
1-Methylcarbamoyl-2,3,6-trimethyl-2,6-diäthyl-4-piperidinyl-methylcarbamat
4-Acetylamino-1,2,2,6,6-pentamethylpiperidin
N,N'-Bis-(2,2,6,6-tetramethyl-4-piperidinyl)-hexamethylen-1,6-diamin
N,N'-Bis-(2,2,6,6-tetramethyl-4-piperidinyl)-N,N'-dibutyl-adipamid
1-Benzyl-2,2,6,6-tetramethyl-4-diäthanolamino-piperidin
4-Acrylamido-1,2,2,6,6-pentamethylpiperidin
9-Aza-8,8,10,10-tetramethyl-1,5-dioxaspiro[5.5]undecan
9-Aza-3-äthyl-3-acetoxymethyl-9-acetyl-8,8,10,10-tetramethyl-1,5-dioxaspiro[5.5]undecan
1,3,8-Triaza-3,7,7,9,9-pentamethylspiro[4.5]decan-2,4-dion
3-n-Octyl-1,3,8-triaza-7,7,9,9-tetramethylspiro[4.5]decan-2,4-dion
2,2,4,4-Tetramethyl-7-oxa-3,20-diaza-21-oxo-dispiro-[5,1,11,2]-heneicosan
1,3-Di(2,2,6,6-tetramethyl-4-piperidinyl)-imidazolidinon-2
2,4-Diphenoxy-6-(2,2,6,6-tetramethyl-4-piperidinoxy)-s-triazin
2,4,6-Tri[N-(2,2,6,6-tetramethyl-4-piperidinyl)-butylamino]-s-triazin
2-Dibutylamino-4,6-di[N-(1,2,2,6,6-pentamethyl-4-piperidinyl)-äthylamino]-s-triazin
1,4-Bis-(2,2,6,6-tetramethyl-1-piperidino)-buten-2
Di-[2-(2,2,6,6-tetramethyl-1-piperidino)-äthyl]-adipat
2,2,6,6-Tetramethylpiperidin-1-essigsäure-n-octylester
Polyester aus Bernsteinsäure, Adipinsäure, Sebacinsäure, Dibutylmalonsäure, Oxalsäure oder Isophthalsäure und 1-Hydroxyäthyl-2,2,6,6-tetramethyl-4-hydroxypiperidin
Polyamid aus Bernsteinsäure, Adipinsäure oder Phthalsäure und 1-(3-Aminopropyl)-2,2,6,6-tetramethyl-4-aminopiperidin
Polyamid aus Oxalsäure oder p-Phenylendiessigsäure und N,N'-Di(1,2,2,6,6-pentamethyl-4-piperidinyl)-1,6-diaminohexan
Tetrakis-(2,2,6,6-tetramethyl-4-piperidinyl)-1,8,11,18-tetra-aza-octadecan
Polyamin aus 1,2,2,6,6-Pentamethyl-4-aminopiperidin und Epichlorhydrin oder Bisphenol-A-diglycidäther
Polytriazin aus 2,4-Dichlor-6-N-(1,2,2,6,6-pentamethyl-4-piperidinyl)-äthylamino-s-triazin und N,N'-Bis(2,2,6,6-tetramethyl-4-piperidinyl)-1,6-diaminohexan
Polytriazin aus 2,4-Dichlor-6-(1,1,3,3-tetramethyl-butylamino)-s-triazin und N,N'-Bis(2,2,6,6-tetramethyl-4-piperidinyl)-1,6-diaminohexan
Polymerisat aus 1,2,2,6,6-Pentamethyl-4-methacryloxypiperidin
Copolymerisat aus 1-Benzyl-2,2,6,6-tetramethyl-4-acrylamidopiperidin und N-Butylacrylamid
Salz aus 1 Mol $H_3PO_4$ und 1 Mol Adipinsäure-di-(1,2,2,6,6-pentamethyl-4-piperidinyl)-ester
Salz aus 2 Mol Bis-(3,5-di-tert.butyl-4-hydroxybenzyl)-malonsäure und 1 Mol 2,2,6,6-Tetramethyl-4-lauroyl-oxypiperidin

1:1-Komplex von Bis-(2,2,6,6-tetramethyl-4-piperidinyl)-sebacat und Nickel-II-acetylacetonat
1:2-Komplex von Bis-(1,2,2,6,6-pentamethyl-4-piperidinyl)-adipat und Nickel-II-acetat

Weitere Beispiele für erfindungsgemäss verwendbare Piperidin-Lichtschutzmittel sind in der EP - A - 0002753 beschrieben.

In bestimmten Fällen kann es von Vorteil sein, ein Gemisch von 2 oder mehr Lichtschutzmitteln aus der Reihe der Polyalkylpiperidinderivate zu verwenden. Die Menge an Lichtschutzmittel in der photohärtbaren Zusammensetzung beträgt 0,02 bis 5 Gew.-%, vorzugsweise 0,5 bis 2 Gew.-% und hängt vom gewünschten Grad der Stabilisierung ab.

Als Komponente (d) können die Zusammensetzungen weitere Additive enthalten wie sie in Kunststofftechnologie und insbesondere wie sie in der Technologie von photohärtbaren Ueberzügen üblich sind. Beispiele hierfür sind Stabilisatoren zur Erhöhung der Dunkellagerstabilität, Kettenübertragungsmittel, Farbstoffe, Pigmente, Paraffine oder Wachse, Stabilisatoren zur Erhöhung der thermischen Stabilität, Antioxydantien oder Verlaufshilfsmittel. Pigmente können in den Zusammensetzungen in Mengen bis zu 50% vorliegen. Die übrigen Zusätze werden hingegen nur in kleinen Mengen verwendet.

Das Mischen der Komponenten geschieht nach den üblichen Methoden. Bevorzugt wird als Komponente (a) eine flüssige Verbindung bzw. Gemisch verwendet. In diesem Falle können (b), (c) und gegebenenfalls (d) in die Komponente (a) durch Rühren eingemischt werden. Hierbei kann eine homogene Lösung resultieren oder eine Dispersion. In beiden Fällen entsteht eine Zusammensetzung, die sich nach den üblichen Methoden der Beschichtungstechnik auf feste Oberflächen aufbringen lässt, beispielsweise durch Streichen, Tauchen, Besprühen oder Walzen. Als Substrat kommen jede Art von festen Materialien in Frage wie z.B. Metall, Holz, Kunststoffe, Glas, Keramik, Papier, Textilien. Von besonderer Bedeutung ist die Beschichtung von Holz, z.B. für Möbel, Fussböden oder Wandelemente, die Beschichtung von Dekorationsplatten, beispielsweise bedruckten Papp-, Kunststoff- oder Holzfaserplatten, und die Beschichtung von Kunststoffen wie z.B. von Fussbodenbelägen oder von Möbelfolien. Die erfindungsgemässen Zusammensetzungen eignen sich auch zur Herstellung licht-beständiger Formmassen, vor allem von transparenten Formmassen, beispielsweise von Platen aus Acrylglas oder ungesättigten Polyestern.

Die Polymerisation des aufgetragenen Ueberzuges bzw. der Formmasse erfolgt nach den bekannten Methoden der Photopolymerisation durch Bestrahlung mit Licht, das reich an kurzwelliger Strahlung ist. Als Lichtquellen sind z.B. Quecksilbermitteldruck-, -hochdruck- und -niederdruckstrahler, sowie superaktinische Leuchtstoffröhren geeignet, deren Emissionsmaxima im Bereich zwischen 250 und 400 nm liegen.

Die nötige Belichtungszeit muss für jede Zusammensetzung bei der jeweiligen Schichtdicke und Art der Strahlenquelle experimentell ermittelt werden. Für dünne Schichten liegt die Belichtungszeit — je nach Strahlenquelle — bei etwa 0,1 bis 10 Sekunden. Als Mass der Härtung kann zunächst die Wischfestigkeit der Oberfläche beurteilt werden. Ein exakteres Mass, das auch ein Bild über die Durchhärtung gibt, ist die Messung der Pendelhärte nach König (DIN 33 157). Der Härtungsgrad von Formmassen kann durch Messung der Barcol-Härte oder der Shore-D-Härte beurteilt werden.

Die Vergilbung der Ueberzüge und Formmassen kann durch spektroskopische Messung des Yellowness Index (YI) nach ASTM—D 1925/63 T oder des Transmissionsverlustes bei 400 nm gemessen werden.

Die folgenden Beispiele zeigen die Anwendung von erfindungsgemässen Gemischen im Vergleich mit dem Stand der Technik. Hierin bedeuten Teile Gewichtsteile, Prozente Gewichtsprozente, soweit nichts anderes angegeben. Die Temperatur ist in Celsiusgraden angegeben.

Beispiel 1

Die folgenden Versuche zeigen die Vergilbung von photopolymerisierten transparenten Ueberzügen auf Basis eines Polyurethanacrylates. Verwendet werden Gemische der folgenden *Grundrezeptur:*

70 Teile Polyurethanacrylat auf Basis Tolylendiisocyanat der Fa. UCB, Brüssel (EBECRYL 204)

27 Teile 1.6-Hexandiol-diacrylat

3 Teile Photoinitiator

Hierzu kommen 0 oder 1 oder 2 Teile Lichtschutzmittel, entsprechend Tabelle 1.

Als Photoinitiatoren wurden verwendet:

A = Methyl-phenylglyoxylat (erfindungsgemäss)

B = Benzil-dimethylketal (als Vergleich)

C = $\alpha$-Diäthoxy-acetophenon (als Vergleich)

Als Lichtschutzmittel wurde verwendet:

LS I = Bis-(2,2,6,6-tetramethyl-4-piperidinyl)-sebacat.

Die Mischungen wurden in einer Schichtdicke von 70—80 $\mu$ auf weiss gestrichene Aluminiumbleche aufgetragen und in einem HANOVIA-laborgerät 1,5 Sekunden belichtet. Die Proben wurden 1 Woche im Dunkeln gelagert und anschliessend 720 Stunden in einem XENOTEST 150 belichtet. Tabelle 1 zeigt den Yellowness-Index gemäss ASTM—D 1925/63 T unmittelbar nach der Photohärtung, nach 24 Stunden Dunkellagerung sowie nach verschiedenen Xenotest-Belichtungszeiten. Je länger die Belichtungszeiten, desto deutlicher sind die Unterschiede zwischen unstabilisierten und erfindungsgemäss lichtstabilisierten Proben zu erkennen, während bei den Vergleichsproben praktisch kein Unterschied zu erkennen ist.

TABELLE 1

| Photo-initiator | Lichtschutz-mittel | Yellowness-Index nach | | | | |
|---|---|---|---|---|---|---|
| | | UV-Hartung | 1 Woche Dunkellagerung | Bestrahlung im Xenotest 150 | | |
| | | | | Std. 24 | Std. 216 | Std. 720 |
| A | – | 2,7 | 2,7 | 2,4 | 4,2 | 10,3 |
| | 1% LS I | 3,5 | 3,5 | 3,2 | 3,5 | 6,5 |
| | 2% LS I | 2,9 | 3,1 | 2,7 | 3,2 | 5,7 |
| B (Vergleich) | – | 5,6 | 3,2 | 11,5 | 12,3 | 18,2 |
| | 1% LS I | 7,8 | 3,5 | 11,4 | 13,3 | 17,6 |
| | 2% LS I | 6,3 | 4,3 | 12,0 | 15,2 | 19,8 |
| C (Vergleich) | – | 2,3 | 4,2 | 5,3 | 5,8 | 10,2 |
| | 1% LS I | 3,4 | 12,3 | 3,7 | 6,0 | 9,6 |
| | 2% LS I | 6,7 | 15,2 | 5,3 | 7,3 | 12,1 |

Beispiel 2

Die Versuche des Beispiels 1 wurden wiederholt, jedoch wurden die Proben im Xenotest 150 unter gleichzeitiger Bewitterung belichtet. Die Ergebnisse der Tabelle 2 sind ähnlich denen des Beispiels 1.

TABELLE 2

| Photo-initiator | Lichtschutz-mittel | Yellowness-Index nach | | | | |
|---|---|---|---|---|---|---|
| | | UV-Hartung | 1 Woche Dunkellagerung | Bestrahlung im Xenotest 150, feucht | | |
| | | | | Std. 24 | Std. 216 | Std. 720 |
| A | – | 2,9 | 3,1 | 3,4 | 5,3 | 12,0 |
| | 1% LS I | 3,5 | 3,6 | 3,4 | 3,9 | 7,6 |
| | 2% LS I | 2,9 | 2,8 | 2,4 | 2,8 | 5,2 |
| C (Vergleich) | – | 2,4 | 4,4 | 5,0 | 8,3 | 13,5 |
| | 1% LS I | 3,8 | 11,8 | 4,7 | 5,7 | 9,2 |
| | 2% LS I | 7,3 | 15,7 | 7,4 | 9,6 | 13,6 |

Beispiel 3

Die folgenden Versuche zeigen den Einfluss der verwendeten Lichtschutzmittel auf die Geschwindigkeit der Photopolymerisation, gemessen an der Pendelhärte des polymerisierten Filmes.

Die verwendete Grundrezeptur ist dieselbe wie in Beispiel 1. Als Photoinitiator wurde Methylphenylglyoxylat verwendet.

Als Lichtschutzmittel wurden verwendet:

Erfindungsgemässe Piperidinderivate:

LS I = Bis-(2,2,6,6-tetramethyl-4-piperidinyl)-sebacat

LS IV = Bis-(1,2,2,6,6-pentamethyl-4-piperidinyl)-sebacat

LS V = 1-Hydroxyäthyl-2,2,6,6-tetramethyl-4-diäthanolamino-piperidin

LS VI = 4-Hydroxy-2,2,6,6-tetramethylpiperidin

LS VII = 4-Amino-2,2,6,6-tetramethylpiperidin

LS VIII = 1-Hexyl-2,2,6,6-tetramethyl-4-hydroxypiperidin

LS IX = 1-(2-Hydroxybutyl)-2,2,6,6-tetramethyl-4-piperidin

UV-Absorber als Vergleich:

UV I = 2-Hydroxy-4-dodecyloxy-benzophenon

UV II = 2-(2′-Hydroxy-3′,5′-di-tert.amyl-phenyl)-benztriazol

Die Versuche wurden wie in Beispiel 1 beschrieben durchgeführt. Nach einer Belichtung von 2,2 Sekunden (3 Durchgänge) im HANOVIA-Gerät wurden die Proben 30 Minuten gelagert und dann die Pendelhärte gemäss DIN 33 157 gemessen.

TABELLE 3

| Gew.–% Lichtschutzmittel | Pendelhärte nach König (Sekunden) nach 2,2 Sek. Belichtungszeit |
|---|---|
| – | 28 |
| 1 % LS I | 43 |
| 1 % LS IV | 28 |
| 1 % LS V | 36 |
| 1 % LS VI | 39 |
| 1 % LS VII | 41 |
| 1 % LS VIII | 38 |
| 1 % LS IX | 28 |
| 1 % UV I | <10 |
| 1 % UV II | <10 |

Man ersieht daraus, dass die als Vergleich verwendeten UV-Absorber die Polymerisation verzögern, während die erfindungsgemässen Piperidinderivate die Härtung zum Teil sogar beschleunigen.

**Patentansprüche**

1. Photohärtbares Gemisch bestehend aus

(a) einer oder mehreren äthylenisch ungesättigten, photohärtbaren Verbindungen,
(b) mindestens einem Photoinitiator der Formel I

$$Ar-\overset{\displaystyle O}{\overset{\|}{C}}-COOR \qquad (I)$$

worin Ar einen unsubstituierten oder durch $C_1$—$C_4$-Alkyl, $C_1$—$C_4$-Alkoxy, Phenoxy, $C_1$—$C_4$-Alkylthio, Phenylthio oder Halogen mono-, di- oder trisubstituierten $C_6$—$C_{14}$-Arylrest darstellt und R $C_1$—$C_{12}$-Alkyl, $C_5$—$C_8$-Cycloalkyl, $C_6$—$C_{10}$-Aryl oder Alkaryl, $C_7$—$C_{11}$-Aralkyl oder $C_3$—$C_8$-Alkoxyalkyl darstellt,
(c) mindestens einem Lichtschutzmittel aus der Klasse der Polyalkylpiperidinderivate und
(d) gegebenenfalls einem oder mehreren sonstigen in der Kunststofftechnologie üblichen Additiven.

2. Gemisch gemäss Anspruch 1, bestehend aus

(a) einer oder mehreren photopolymerisierbaren Verbindungen aus der Reihe der Acryl- und Methacrylsäurederivate,
(b) einem Photoinitiator der Formel I, worin Ar Phenyl oder Alkylphenyl ist und R $C_1$—$C_4$-Alkyl ist,
(c) einem Lichtschutzmittel aus der Klasse der Polyalkylpiperidine und
(d) gegebenenfalls einem oder mehreren sonstigen in photohärtbaren Gemischen üblichen Additiven.

3. Gemisch gemäss Anspruch 2, in welchem das Lichtschutzmittel (c) ein Acryl- oder Methacrylsäurederivat eines Polyalkylpiperidins ist.

4. Gemisch gemäss Anspruch 1, bestehend aus

(a) einem Polyurethanacrylat oder dessen Gemisch mit anderen Acryl- oder Methacrylsäurederivaten,

(b) einem Photoinitiator der Formel I, worin Ar Phenyl ist und R Methyl oder Aethyl ist,

(c) einem Lichtschutzmittel aus der Klasse der Polyalkylpiperidine und

(d) gegebenenfalls einem oder mehreren sonstigen in photohärtbaren Gemischen üblichen Additiven.

5. Gemisch gemäss Anspruch 4, worin das Lichtschutzmittel (c) ein Acryl- oder Methacrylsäurederivat eines Polyalkylpiperidins ist.

6. Gemisch gemäss Anspruch 1, dadurch gekennzeichnet, dass es 0,1 bis 10 Gew.-% der Komponente (b) enthält.

7. Gemisch gemäss Anspruch 1, dadurch gekennzeichnet, dass es 0,02 bis 5 Gew.-%, vorzugsweise 0,5 bis 2 Gew.-% der Komponente (c) enthält.

**Claims**

1. A photocurable composition consisting of (a) one or more ethylenically unsaturated, photocurable compounds, (b) at least one photo-initiator of the formula I

$$Ar-\overset{\overset{\displaystyle O}{\|}}{C}-COOR \qquad (I)$$

in which Ar is a $C_6$—$C_{14}$-aryl radical which is unsubstituted or mono-, di- or tri-substituted by $C_1$—$C_4$-alkyl, $C_1$—$C_4$-alkoxy, phenoxy, $C_1$—$C_4$-alkylthio, phenylthio or halogen and R is $C_1$—$C_{12}$-alkyl, $C_5$—$C_6$-cycloalkyl, $C_6$—$C_{10}$-aryl or alkaryl, $C_7$—$C_{11}$-aralkyl or $C_3$—$C_6$-alkoxyalkyl, (c) at least one light stabiliser from the category of the polyalkylpiperidine derivatives and (d) if desired one or more other additives customary in plastics technology.

2. A composition according to claim 1, consisting of (a) one or more photopolymerisable compounds from the series comprising the acrylic and methacrylic acid derivatives, (b) a photo-initiator of the formula I, in which Ar is phenyl or alkylphenyl and R is $C_1$—$C_4$-alkyl, (c) a light stabiliser from the category of the polyalkylpiperidines and (d) if desired one or more other additives customary in the technology of photocurable compositions.

3. A composition according to claim 2, in which the light stabiliser (c) is an acrylic or methacrylic acid derivative of a polyalkylpiperidine.

4. A composition according to claim 1, consisting of (a) a polyurethane acrylate or a mixture thereof with other acrylic or methacrylic acid derivatives, (b) a photo-initiator of the formula I in which Ar is phenyl and $R^1$ is methyl or ethyl, (c) a light stabiliser from the category of the polyalkylpiperidines and (d) if desired one or more other additives customary for photocurable compositions.

5. A composition according to claim 4, in which the light stabiliser (c) is an acrylic or methacrylic acid derivative of a polyalkylpiperidine.

6. A composition according to claim 1, which contains 0.1 to 10% by weight of component (b).

7. A composition according to claim 1, which contains 0.02 to 5% by weight, preferably 0.5 to 2% by weight, of component (c).

**Revendications**

1. Composition photodurcissable constituée:

(a) d'un ou plusieurs composés éthyléniques photodurcissables,

(b) d'au moins un photo-initiateur répondant à la formule I:

$$Ar-\overset{\overset{\displaystyle O}{\|}}{C}-COOR \qquad (I)$$

dans laquelle Ar représente un radical aryle en $C_6$—$C_{14}$ non substitué ou portant un, deux ou trois substituants choisis dans l'ensemble constitué par les alkyles en $C_1$—$C_4$, les alcoxy en $C_1$—$C_4$, le phénoxy, les alkylthio en $C_1$—$C_4$, le phénylthio et les halogènes, et R représente un alkyle en $C_1$—$C_{12}$, un cycloalkyle en $C_5$ ou $C_6$, un aryle en $C_6$—$C_{10}$, un alkylaryle, un aralkyle en $C_7$—$C_{11}$ ou un alcoxyalkyle en $C_3$—$C_6$,

(c) d'au moins un stabilisant à la lumière de la catégorie des dérivés de polyalkyl-pipéridines et

(d) éventuellement d'un ou plusieurs autres additifs usuels dans la technologie des matières plastiques.

2. Composition selon la revendication 1, constituée:

(a) d'un ou plusieurs composés photopolymérisables appartenant à la catégorie des dérivés de l'acide acrylique ou de l'acide méthacrylique,

(b) d'un photo-initiateur de formule I dans lequel Ar représente un radical phényle ou alkylphényle et R un radical alkyle en $C_1$—$C_4$,

(c) d'un stabilisant à la lumière de la catégorie des polyalkyl-pipéridines et

(d) éventuellement d'un ou plusieurs des autres additifs couramment utilisés dans la technologie des matières photodurcissables.

3. Composition selon la revendication 2, dans laquelle le stabilisant à la lumière (c) est un dérivé acrylique ou méthacrylique d'une polyalkyl-pipéridine.

4. Composition selon la revendication 1, constituée:

(a) d'un polyuréthanne-acrylate ou d'un mélange d'un tel composé avec d'autres dérivés de l'acide acrylique ou de l'acide méthacrylique,

(b) d'un photo-initiateur de formule I dans lequel Ar représente un radical phényle et R un radical méthyle ou éthyle,

(c) d'un stabilisant à la lumière de la catégorie des polyalkyl-pipéridines et

(d) éventuellement d'un ou plusieurs des autres additifs usuels pour les matières photodurcissables.

5. Composition selon la revendication 4, dans laquelle le stabilisant à la lumière (c) est un dérivé acrylique ou méthacrylique d'une polyalkyl-pipéridine.

6. Composition selon la revendication 1, caractérisée en ce qu'elle contient de 0,1 à 10% en poids de la composante (b).

7. Composition selon la revendication 1, caractérisée en ce qu'elle contient de 0,02 à 5% en poids, de préférence de 0,5 à 2% en poids, de la composante (c).